**Europäisches Patentamt**

**European Patent Office**

**Office européen des brevets**

(11) Numéro de publication: **0 011 571**

**A1**

# DEMANDE DE BREVET EUROPEEN

(21) Numéro de dépôt: **79400866.4**

(22) Date de dépôt: **14.11.79**

(51) Int. Cl.³: **H 03 H 15/02**
**H 01 L 27/10**

(30) Priorité: **21.11.78 FR 7832766**

(43) Date de publication de la demande:
**28.05.80 Bulletin 80/11**

(84) Etats Contractants Désignés:
**DE GB NL**

(71) Demandeur: **"THOMSON-CSF"**
**173, boulevard Haussmann**
**F-75360 Paris Cedex 08(FR)**

(72) Inventeur: **Benoit-Gonin, Roger**
**"THOMSON-CSF" - SCPI 173, bld Haussmann**
**F-75360 Paris Cedex 08(FR)**

(72) Inventeur: **Fontanes, Sylvain**
**"THOMSON-CSF" - SCPI 173, bld Haussmann**
**F-75360 Paris Cedex 08(FR)**

(72) Inventeur: **Picquendar, Jean-Edgar**
**"THOMSON-CSF" - SCPI 173, bld Haussmann**
**F-75360 Paris Cedex 08(FR)**

(74) Mandataire: **Benichou, Robert et al,**
**"THOMSON-CSF" - SCPI 173 bld Haussmann**
**F-75360 Paris Cedex 08(FR)**

(54) **Filtre récursif à transfert de charges électriques.**

(57) Le filtre, ayant tous ses coefficients de pondération positifs, une quantité de charges pondérée est recueillie par une
ligne (L) sous l'une des électrodes élémentaires de chaque
électrode de pondération (20). Un dispositif de lecture des
charges (D) est couplé à la ligne et fournit un signal électrique
(S') envoyé sur l'entrée négative d'un amplificateur différentiel (6), qui reçoit sur son entrée positive la tension électrique
d'entrée échantillonnée du filtre. Le signal électrique de sortie
du filtre (S) est pris, sous faible impédance, à la sortie de
l'amplificateur différentiel (6), ce signal (S) étant ré-injecté à
l'entrée du filtre, par des moyens d'injection (1).

FIG.2

1

# FILTRE RECURSIF A TRANSFERT DE CHARGES ELECTRIQUES

La présente invention concerne un filtre récursif à transfert des charges électriques.

On rappelle qu'un filtre à transfert de charges électriques comporte essentiellement :

- un registre à décalages à transfert de charges électriques, réalisé sur un substrat semi-conducteur et recouvert d'une couche isolante sur laquelle sont disposées des électrodes de transfert, disposées parallèlement les unes aux autres et transversalement par rapport à la direction des charges. Ces électrodes assurent sur application périodique de potentiels donnés le transfert de charges dans le substrat, d'un étage du registre au suivant ;

- des moyens de pondération reliés à la sortie des étages du registre à décalages qui affectent d'un coefficient de pondération la quantité de charges ayant parcouru chaque étage.

Dans un filtre récursif, le signal électrique de lecture de quantités de charges pondérées est injecté à nouveau à l'entrée du filtre, après avoir été déphasé de 180º. Ce signal est généralement envoyé sur l'entrée négative d'un amplificateur différentiel qui reçoit sur son entrée positive des échantillons du signal électrique d'entrée à filtrer. Le signal de sortie de l'amplificateur différentiel est appliqué à des moyens assurant l'injection de charges, situés à l'entrée du registre selon la direction de transfert des charges.

Dans les filtres récursifs selon l'art connu, le signal électrique de sortie du filtre est constitué par le signal électrique de lecture des quantités de charges pondérées recueilli en sortie du registre à décalages, avant l'amplificateur différentiel.

La présente invention concerne un filtre récursif à transfert de charges électriques dans lequel le signal électrique de sortie du filtre est pris, sous une faible impédance, à la sortie de l'amplificateur différentiel.

Le filtre récursif selon l'invention présente notamment l'avantage, dans le cas où tous ses coefficients de pondération sont positifs, d'économiser un amplificateur. Il présente donc l'avantage de diminuer la surface de substrat semi-conducteur nécessaire à sa réalisation ; le coût et l'encombrement du filtre récursif à coefficients de pondération positifs réalisé sont ainsi diminués.

D'autres objets, caractéristiques et résultats de l'invention ressortiront de la description suivante donnée à titre d'exemple non limitatif et illustrée par les figures annexées qui représentent :
- la figure 1, un schéma de principe d'un filtre récursif à transfert de charges électriques selon l'invention ;
- la figure 2, un mode de réalisation d'un filtre récursif à coefficients de pondération positifs selon l'invention.

Sur les différentes figures, les mêmes repères désignent les mêmes éléments et, pour des raisons de clarté, les cotes et proportions des différents éléments n'ont pas été respectées.

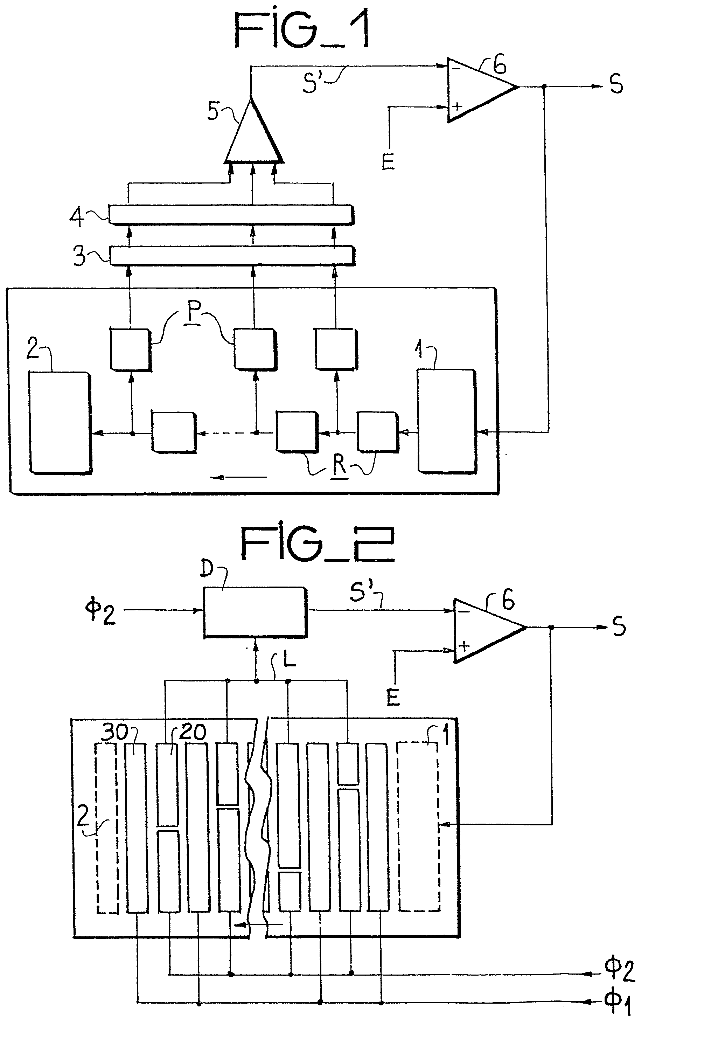

La figure 1 représente un schéma de principe d'un filtre récursif à transfert de charges électriques selon l'invention.

Le filtre récursif selon l'invention comporte

. . .

3

un registre à décalages à transfert de charges électriques R qui est réalisé sur un substrat semi-conducteur, recouvert d'une couche isolante. Le sens de
transfert des charges d'un étage du registre au suivant est indiqué par une flèche.

Des moyens 1, situés à l'entrée du registre
selon le sens de transfert des charges, permettent
l'injection dans le registre à décalages de quantités
de charges correspondant au signal électrique de sortie S du filtre récursif selon l'invention.

Des moyens 2 permettent l'évacuation des charges ayant parcouru le dernier étage du registre.

Des moyens de pondération P, reliés à la sortie des étages du registre, affectent d'un coefficient de pondération la quantité de charges ayant
parcouru chaque étage.

Des moyens 3 fixent le signe des coefficients
de pondération, des moyens de lecture 4 et de sommation 5 des quantités de charges pondérées fournissent
un signal électrique S' envoyé sur l'entrée négative
d'un amplificateur différentiel 6. Cet amplificateur
différentiel reçoit sur son entrée positive la tension électrique d'entrée E échantillonnée du filtre
récursif. Le signal de sortie S de l'amplificateur
est pris à la sortie de l'amplificateur différentiel
6, cette sortie étant reliée aux moyens assurant
l'injection de charges 1.

Le signal de sortie S du filtre récursif selon
l'invention est ainsi obtenu sous une faible impédance.

La figure 2 représente un mode de réalisation
d'un filtre récursif à coefficients de pondération

4

positifs selon l'invention. Les filtres récursifs à coefficients de pondération positifs présentent de grands avantages en raison de la simplicité de leur structure et surtout en raison de la simplicité de leurs moyens de lecture. Ils ne comportent qu'un seul dispositif de lecture assurant la conversion des charges en tension de sortie, alors que les filtres à coefficients de pondération positifs et négatifs comportent deux dispositifs de lecture associés à un amplificateur différentiel. La réalisation des filtres à coefficients de pondération positifs est ainsi facilitée, leurs performances au point de vue du bruit résiduel et de la linéarité sont améliorées, en raison notamment de la suppression des signaux de mode commun dont il faut tenir compte lorsqu'on utilise un amplificateur différentiel. Par ailleurs, les synthèses mises en oeuvre pour ces filtres conduisent à des valeurs des coefficients de pondération, et de la somme de ces coefficients, plus élevées et donc à un niveau de sortie accru pour un niveau d'entrée donné.

Sur la figure 2, le registre à décalages est réalisé par des électrodes de transfert 30, disposées sur la couche isolante recouvrant le substrat, parallèlement les unes aux autres et transversalement par rapport à la direction des charges. Ces électrodes assurent sur application périodique de potentiels donnés le transfert des charges dans le substrat. Les moyens de pondération P des quantités de charges peuvent être constitués par des ponts de résistances. Ils peuvent être aussi constitués par des électrodes de pondération 20, intercalées sur le registre, avec

5

les électrodes de transfert. Chaque électrode de pondération est divisée en au moins deux électrodes élémentaires séparées selon la direction de transfert des charges par une coupure. Une quantité de charges pondérée peut ainsi être recueillie sous chaque électrode élémentaire. Comme les électrodes de transfert, les électrodes de pondération assurent sur application périodique de potentiels donnés le transfert des charges dans le substrat.

Sur la figure 2, une électrode de pondération est intercalée entre chaque électrode de transfert. Les électrodes de transfert et de pondération sont respectivement soumises à des potentiels $\emptyset_1$ et $\emptyset_2$. Une ligne L permet le recueil des quantités de charges se trouvant sous l'une des électrodes élémentaires de chaque électrode de pondération et constitue les moyens de sommation 5 du filtre. Les moyens de lecture 4 des quantités de charges électriques et les moyens fixant le signe des coefficients de pondération 3 sont constitués de façon connue par un dispositif D de lecture des charges en courant ou en tension. Le dispositif D est couplé à la ligne de recueil et fournit un signal électrique de sortie S' qui, comme sur la figure 1, est envoyé sur l'entrée négative d'un amplificateur différentiel 6.

Le potentiel $\emptyset_2$ peut être appliqué aux électrodes élémentaires sous lesquelles des charges sont recueillies par la ligne L, par l'intermédiaire du dispositif de lecture D.

Dans les filtres récursifs selon l'art antérieur, le signal électrique S' constitue le signal de sortie du filtre. Dans le cas d'un filtre à coefficients de

pondération positifs, il faut alors intercaler entre le dispositif de lecture D et l'amplificateur différentiel 6, un amplificateur permettant d'obtenir le signal de sortie du filtre sous faible impédance. Le filtre récursif à coefficients de pondération positifs selon l'invention permet d'économiser cet amplificateur.

Tout filtre récursif différant de ceux exposés par le nombre d'électrodes de transfert intercalées entre chaque électrode de pondération ne sort pas du cadre de l'invention.

L'invention s'applique au filtrage de signaux électriques.

7

## REVENDICATIONS

1. Filtre récursif à transfert de charges électriques, comportant :

- un registre à décalages à transfert de charges électriques (R) comportant plusieurs étages, ce registre étant réalisé sur un substrat semi-conducteur recouvert d'une couche isolante, des électrodes de transfert (30), constituant ces étages, étant disposées sur la couche isolante, parallèlement les unes aux autres et transversalement par rapport à la direction des charges et assurant sur application périodique de potentiels donnés le transfert de charges dans le substrat d'un étage du registre au suivant ;

- des moyens (1) assurant l'injection de charges dans le registre à décalages, situés à l'entrée du registre selon le sens de transfert des charges ;

- des moyens de pondération (P) reliés à la sortie des étages du registre qui affectent d'un coefficient de pondération la quantité de charges ayant parcouru chaque étage ;

- des moyens (3) fixant le signe des coefficients de pondération ;

- des moyens de lecture (4) et de sommation (5) des quantités de charges pondérées, ces moyens fournissant un signal électrique (S') envoyé sur l'entrée négative d'un amplificateur différentiel (6), qui reçoit sur son entrée positive la tension électrique d'entrée échantillonnée (E) du filtre récursif, la sortie de l'amplificateur différentiel étant reliée aux moyens assurant l'injection de charges (1) ;

- des moyens (2) assurant l'évacuation des charges ayant parcouru le dernier étage du registre ;

8

ce filtre étant caractérisé en ce que le signal électrique de sortie (S) du filtre récursif est pris, sous une faible impédance, à la sortie de l'amplificateur différentiel (6).

2. Filtre selon la revendication 1, caractérisé en ce que les moyens de pondération (P) sont constitués par des électrodes de pondération (20), intercalés sur le registre avec les électrodes de transfert (30), chaque électrode de pondération étant divisée en au moins deux électrodes élémentaires séparées, selon la direction de transfert des charges, par une coupure, une quantité de charges pondérée pouvant être recueillie sous chaque électrode élémentaire, les électrodes de transfert et de pondération assurant sur application périodique de potentiels donnés ($\phi_1$, $\phi_2$) le transfert des charges dans le substrat.

3. Filtre selon la revendication 2, caractérisé en ce que tous ses coefficients de pondération sont positifs et en ce que les moyens de sommation algébrique sont constitués par une ligne de recueil (L) des quantités de charges se trouvant sous l'une des électrodes élémentaires de chaque électrode de ponde-ration (20), les moyens de lecture des quantités de charges électriques et les moyens fixant le signe des coefficients de pondération étant constitués par un dispositif de lecture des charges (D), qui est couplé à la ligne de recueil et qui fournit le signal électrique (S') envoyé sur l'entrée négative de l'ampli-ficateur différentiel.

## FIG_1

## FIG_2

Office européen
des brevets

**RAPPORT DE RECHERCHE EUROPEENNE**

0011571

Numéro de la demande

EP 79 40 0866

| | **DOCUMENTS CONSIDERES COMME PERTINENTS** | | CLASSEMENT DE LA DEMANDE (Int. Cl. 3) |
|---|---|---|---|
| Catégorie | Citation du document avec indication, en cas de besoin, des parties pertinentes | Revendica-tion concernée | |
| | IEEE TRANSACTIONS ON AUTOMATIC CONTROL, vol. AC-22, no. 4, August 1977, pages 680-682 New York, U.S.A. E.S. McVEY et al.: "The application of Charge-Coupled Device Processors in Automatic-Control Systems" <br><br> * Figure 2; page 682, colonne de gauche, lignes 12-31 * <br><br> -- | 1 | H 03 H 15/02 H 01 L 27/10 |
| | DE - A - 2 820 836 (THOMSON CSF) <br> * Figures 1,2; page 6, lignes 15-20 * <br> & FR - A - 2 390 857 <br><br> -- | 2 | **DOMAINES TECHNIQUES RECHERCHES (Int. Cl. 3)** <br><br> H 03 H 15/02 H 01 L 27/10 |
| A | FR - A - 2 373 125 (THOMSON CSF) <br> * En entier * <br><br> ---- | 1 | |

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achevement de la recherche | Examinateur |
|---|---|---|
| La Haye | 26-02-1980 | COPPIETERS |

OEB Form 1503.1 06.78